Europäisches Patentamt

European Patent Office

Office européen des brevets

(19)

(11) Publication number: **0 112 607**
**B1**

## (12) EUROPEAN PATENT SPECIFICATION

(45) Date of publication of patent specification: **18.03.87**

(21) Application number: **83304914.1**

(22) Date of filing: **25.08.83**

(51) Int. Cl.⁴: **H 01 L 29/60,** H 01 L 29/52, H 01 L 29/78

(54) Power MOS transistor.

(30) Priority: **03.09.82 US 414853**

(43) Date of publication of application:
**04.07.84 Bulletin 84/27**

(45) Publication of the grant of the patent:
**18.03.87 Bulletin 87/12**

(84) Designated Contracting States:
**BE DE FR IT NL**

(56) References cited:
**EP-A-0 037 105**
**GB-A-2 033 658**
**GB-A-2 082 385**

**INTERNATIONAL ELECTRON DEVICES MEETING, 8th-10th December 1980, Washington, D.C., Technical Digest, pages 91-94, IEEE, New York, US; J. MENA et al.: "High frequency performance of VDMOS power transistors"**

**ELEKTOR, vol. 8, no. 6, June 1982, pages 6-52 - 6-56, Canterbury, Kent, GB; "Introducing DMOS power FETs"**

(73) Proprietor: **Western Electric Company, Incorporated**
**222 Broadway**
**New York, NY 10038 (US)**

(72) Inventor: **Clarke, Patrick William**
**244 Sagamore Drive**
**Murray Hill New Jersey 07974 (US)**
Inventor: **Helm, George David**
**705 Hain Avenue**
**Reading Pennsylvania 19605 (US)**
Inventor: **Potteiger, Donald Carl**
**9 Larchwood Road**
**Wyomissing Pennsylvania 19610 (US)**

(74) Representative: **Watts, Christopher Malcolm Kelway, Dr. et al**
**Western Electric Company Limited 5, Mornington Road**
**Woodford Green Essex, IG8 0TU (GB)**

## Description

This invention relates to power MOS transistor comprising a plurality of source regions of a first conductivity type formed in the surface of a semiconductor body, a plurality of channel regions adjacent to the source regions, the channel regions having the opposite conductivity type to the first conductivity type, a common drain region of the first conductivity type surrounding the plurality of channel regions, a first insulating layer overlying the channel regions, a sheet of conductive material forming the gate electrode of the transistor and overlying the surface of the body except for the source regions, a second insulating layer overlying the gate electrode and a sheet of conductive material forming the source contact of the transistor and overlying the second insulating layer. A power MOS transistor of this type is, e.g., described in International Electron Devices Meeting, 8th-10th December 1980, Washington, D.C., Technical Digest, pages 91—94, IEEE, New York or in Elektor, vol. 8, no. 6, June 1982, pages 6—52 — 6—56.

In power MOSFET integrated circuits, lead resistance is an important device design consideration. To minimize this resistance, contact conductors of the normal elongated configuration usually found on integrated circuit chips are replaced by sheets of conductive metal or polysilicon. The individual active regions are typically arranged in an array of triangular, square or other polygonal geometry and the gate conductor is characteristically a sheet-like structure interconnecting the multiple gate regions of the array. Source regions are interconnected via a conducting sheet into a parallel network that results in low distributive power losses. The gate layer is isolated from the silicon below it and the source contacting layer above by thin dielectric layer, typically of $SiO_2$ and/or silicon nitride.

While the reductions in power loss have been of significant advantage, an increased complexity of moderately high-power systems has placed a higher premium on switching speed. The improvements described above have increased speed insofar as they have permitted device integration, but further increases of switching speed would be highly desirable.

In the invention as claimed either one or both of the sheets of conductive material forming the gate electrode and the source contact respectively are perforated to reduce the capacitance between the source contact and the gate electrode.

An embodiment of the invention will now be described by way of example with reference to the accompanying drawing in which:—

FIG. 1 is a perspective view partly in section of a typical prior art transistor;

FIG. 2 is a similar view of a device fabricated in accordance with the invention; and

FIG. 3 is a similar view showing the apertured gate conductor with greater clarity.

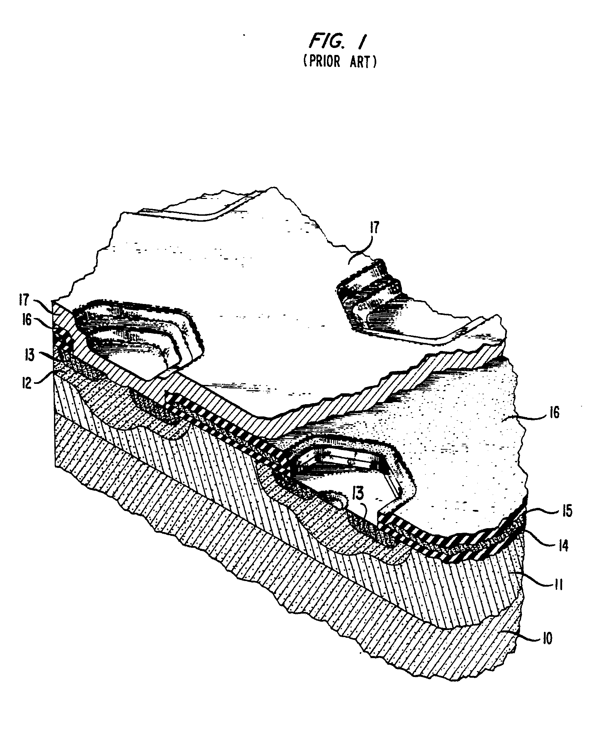

A conventional power MOSFET is illustrated in FIG. 1. It shows substrate 10, collective drain region 11, channels 12 and an array of source regions 13. The structure overlying the substrate includes the gate dielectric 14, the gate conductor 15, upper dielectric layer 16, and the source conductor 17. The gate conductor and source conductor both conduct current with low resistive losses, thus increasing power capability.

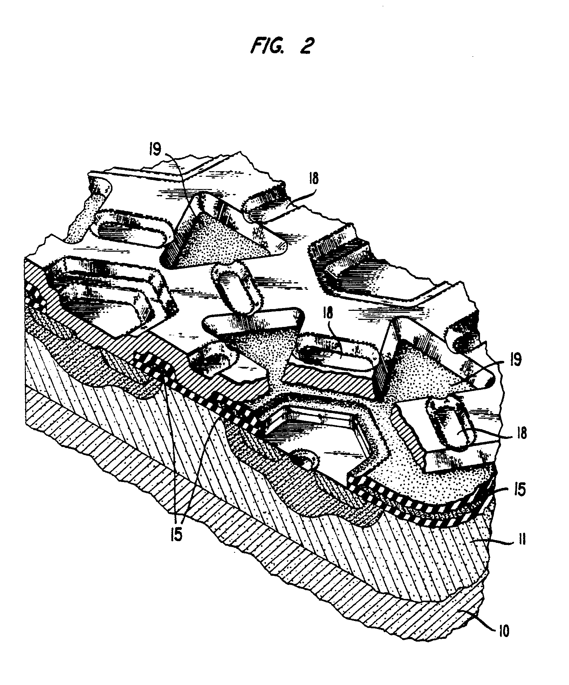

A device with modified electrode configurations is shown in FIG. 2 in which the reference numbers correspond to those of FIG. 1. The FIG. 2 device is capable of significantly higher switching speed than the FIG. 1 device because it reduces the capacitance between the source, gate and drain conductors. The gate conductor 15 appears divided in section but is simply apertured. The apertures result in depressions 18 shown in FIG. 2. The gate conductor apertures significantly reduce the gate to drain capacitance. Apertures 19, formed in the source contacting sheet, reduce the gate to source capacitance. As a consequence of the offset between apertures 18 and 19, both contribute to reducing the gate to source capacitance. Thus, apertures 18 serve a dual role. The device may be made with apertures 18 alone, or in combination with apertures 19 in the source conductor for added benefit. Obviously benefit occurs also from the use of apertures in the source contacting sheet alone.

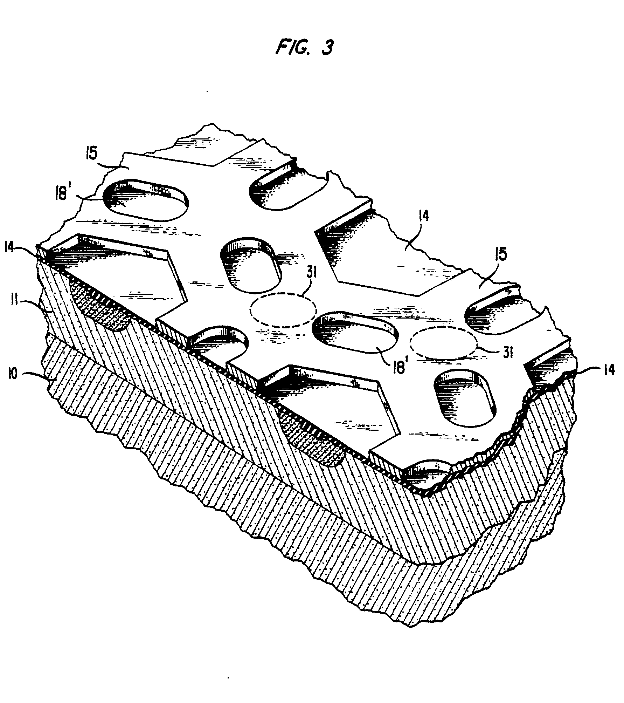

The apertured gate conductor 15, at an earlier stage of fabrication, is shown in FIG. 3. The apertures 18' in the gate conductor do not significantly increase the current density or the resistance of the gate conductor. Alternative locations for the apertures can be used, e.g., those shown at 31 (in phantom).

In a preferred embodiment, the gate electrode 15 is formed of polysilicon; or polysilicon alloyed with a metal to form a more conductive layer or combined with a metal (e.g. Co, Ni, Ta, Ti, Mo, Pt, Pd, etc.) to form conductive intermetallic combinations (e.g., silicides). The gate electrode 15 is also useful as a mask to define the source regions in the substrate. The apertures 18' and the source diffusion windows can be etched simultaneously in the gate electrode structure, thus providing self-alignment. The substrate may include only layer 11.

## Claims

1. A power MOS transistor comprising a plurality of source regions (13) of a first conductivity type formed in the surface of a semiconductor body (10, 11), a plurality of channel regions (12) adjacent to the source regions, the channel regions having the opposite conductivity type to the first conductivity type, a common drain region (11) of the first conductivity type surrounding the plurality of channel regions, a first insulating layer (14) overlying the channel regions, a sheet (15) of conductive material forming the gate electrode of the transistor and overlying the surface of the body except for the source regions, a second insulating layer (16) overlying the gate electrode and a sheet (17) of conductive material forming the source contact of the transistor and overlying the second insulating layer, characterised in that either one or both of the sheets (15, 17) of conductive material forming the gate electrode and the source contact respectively are perforated to reduce the capacitance between the source contact and the gate electrode.

2. A transistor as claimed in claim 1 wherein both the source contact sheet (17) and the gate electrode sheet (15) contain apertures, the source contact sheet (17) containing apertures (19) in regions thereof that do not overlie the apertures (18') of the gate electrode sheet (15).

**Patentansprüche**

1. MOS-Leistungstransistor mit
— einer Vielzahl in der Oberfläche eines Halbleiterkörpers (10, 11) gebildeter Source-Zonen (13) eines ersten Leitungstyps,
— einer Vielzahl benachbart zu den Source-Zonen gelegener Kanal-Zonen (12) des gegenüber dem ersten Leitungstyp entgegengesetzten Leitungstyps,
— einer gemeinsamen Drain-Zone (11) des ersten Leitungstyps, die die Vielzahl Kanalzonen umgibt,
— eine erste Isolierschicht (14), die über den Kanal-Zonen liegt,
— einem Belag (15) aus leitendem Material, der die Gateelektrode des Transistors bildet und über der Oberfläche des Körpers ausgenommen der Source-Zonen liegt,
— einer zweiten Isolierschicht (16), die über der Gateelektrode liegt, und
— einem Belag (17) aus leitendem Material, der den Source-Kontakt des Transistors bildet und über der zweiten Isolierschicht liegt, dadurch gekennzeichnet, daß
— einer oder beide der Beläge (15; 17) aus leitendem Material, die die Gateelektrode bzw. den Source-Kontakt bilden, perforiert sind, um die Kapazität zwischen dem Source-Kontakt und der Gateelektrode zu verringern.

2. Transistor wie in Anspruch 1 beansprucht, wobei
— sowohl der Source-Kontaktbelag (17) als auch der Gate-Elektrodenbelag (15) Öffnungen enthalten derart, daß der Source-Kontaktbelag (17) Öffnungen (19) in Zonen enthält, die nicht über den Öffnungen (18') des Gate-Elektrodenbelags (15) liegen.

**Revendications**

1. Un transistor MOS de puissance comprenant un ensemble de régions de source (13) d'un premier type de conductivité, formées dans la surface d'un bloc de semiconducteur (10, 11), un ensemble de régions de canal (12) adjacentes aux régions de source, les régions de canal ayant le type de conductivité opposé au premier type de conductivité, une région de drain commune (11) du premier type de conductivité entourant l'ensemble de régions de canal, une première couche isolante (14) recouvrant les régions de canal, une pellicule (15) de matière conductrice formant l'électrode de grille du transistor et recouvrant la surface de bloc, sauf dans les régions de source, une seconde couche isolante (16) recouvrant l'électrode de grille et une pellicule (17) de matière conductrice formant le contact de source du transistor et recouvrant la seconde couche, caractérisé en ce que l'une ou l'autre des pellicules (15, 17) de matière conductrice formant respectivement l'électrode de grille et le contact de source, ou les deux, sont perforées pour réduire la capacité entre le contact de source et l'électrode de grille.

2. Un transistor selon la revendication 1, dans lequel la pellicule de contact de source (17) et la pellicule d'électrode de grille (15) comportent toutes deux des ouvertures, la pellicule de contact de source (17) comportant des ouvertures (19) dans des régions de cette pellicule qui ne recouvrent pas les ouvertures (18') de la pellicule d'électrode de grille (15).

0 112 607

*FIG. 1*
(PRIOR ART)

FIG. 2

## FIG. 3